# FASCICULE DE BREVET EUROPEEN

(11) **EP 4 555 748 B1**
(45) Date de publication et mention de la délivrance du brevet: **02.09.2026**
(21) Numéro de dépôt: 23738805.3
(22) Date de dépôt: 12.07.2023
(51) Int. Cl.: H04Q 9/00, G01R 21/00, G01R 19/25, G01R 21/133, G01R 22/06

(54) **SYSTÈME DISTRIBUÉ DE MESURE DE PUISSANCE ÉLECTRIQUE ET PROCÉDÉ ASSOCIÉ**
VERTEILTES STROMMESSSYSTEM UND ZUGEHÖRIGES VERFAHREN
DISTRIBUTED ELECTRIC POWER MEASUREMENT SYSTEM AND ASSOCIATED METHOD

(30) Priorité: 13.07.2022 FR 2207216
(43) Date de publication de la demande: 21.05.2025
(73) Titulaire: SCHNEIDER ELECTRIC INDUSTRIES SAS, 92500 Rueil-Malmaison (FR)
(72) Inventeur: DODELIN, Denis, 38100 Grenoble (FR)
(74) Mandataire: Lavoix
(86) Numéro de dépôt international: PCT/EP2023/069323
(87) Numéro de publication internationale: WO 2024/013235

(56) Documents cités:
- WO-A1-2012/079151
- FR-A1- 2 991 057

## Description

La présente invention concerne un système distribué de mesure de puissance électrique dans une installation électrique alimentée par un signal électrique alternatif cyclique, et un procédé de mesure de puissance électrique associée.

L'invention se situe dans le domaine des systèmes de mesure de puissance électrique dans les installations électriques.

On connaît des dispositifs de mesure de puissance, ou wattmètres, qui sont utilisés dans diverses installations électriques pour surveiller la puissance électrique consommée par l'installation, et mieux protéger l'installation électrique.

L'invention concerne plus particulièrement un système distribué de mesure de puissance, comportant un dispositif de mesure de tension et au moins un dispositif de mesure de courant distant du dispositif de mesure de tension, qui sont adaptés pour communiquer via un protocole de communication, par une liaison de communication radio, ou filaire.

Un système similaire est par exemple divulgué dans le document FR 2 991 057 A1.

Un des problèmes qui se pose dans un tel système est de limiter la consommation électrique de chacun des dispositifs de mesure, en particulier lorsqu'ils sont auto-alimentés.

Par exemple, dans un système distribué de mesure comportant une pluralité de dispositifs de mesure de courant auto-alimentés, adaptés pour communiquer par une liaison de communication radio, selon un protocole de communication radio, par exemple Bluetooth ou ZigBee, on a constaté que le module qui assure la communication radio a une forte consommation électrique.

Il existe alors un besoin de limiter la consommation électrique de tels dispositifs de mesure de courant.

A cet effet, l'invention propose, un système distribué de mesure de puissance électrique dans une installation électrique alimentée par un signal électrique alternatif cyclique, le système comportant un dispositif de mesure de tension et au moins un dispositif de mesure de courant distant du dispositif de mesure de tension, le dispositif de mesure de tension étant configuré pour acquérir un nombre N prédéterminé d'échantillons de tension par cycle dudit signal électrique, chaque dispositif de mesure de courant étant configuré pour acquérir N échantillons de courant par cycle dudit signal électrique, le dispositif de mesure de tension et le ou chaque dispositif de mesure de courant étant adaptés pour communiquer selon un protocole de communication.

Ce système est tel que le dispositif de mesure de tension est configuré pour, durant une période de transmission comportant une pluralité de cycles successifs dudit signal électrique,
- pour chaque cycle, coder les échantillons de tension pour former un mot codé et transmettre ledit mot codé dans une trame de communication dudit protocole de communication au ou à chaque dispositif de mesure de courant,
le ou chaque dispositif de mesure de courant est configuré pour :
- recevoir au moins deux trames de communication successives, chaque trame de communication correspondant à un cycle du signal électrique,
- pour chaque trame, déterminer une méthode de décompression à appliquer et appliquer ladite méthode de décompression pour obtenir N échantillons de tension décodés pour le cycle correspondant,
- calculer une série de N valeurs de puissance pour le cycle correspondant en utilisant les échantillons de courant mesurés et les échantillons de tension décodés.

Avantageusement, le système distribué de mesure de puissance électrique utilise une compression des échantillons de tension transmis au(x) dispositif(s) de mesure de courant, par cycle du signal électrique, ce qui permet de réduire la durée de communication utile, et donc de diminuer la consommation électrique des dispositifs de mesure de courant.

Le système distribué de mesure de puissance électrique selon l'invention peut également présenter une ou plusieurs des caractéristiques ci-dessous, prises indépendamment ou selon toutes les combinaisons techniquement envisageables.

La pluralité de cycles successifs comporte un cycle initial et des cycles suivants, et le dispositif de mesure de tension est configuré pour appliquer, pour les échantillons de tension de chaque cycle courant distinct du cycle initial, une compression par différences mettant en oeuvre pour au moins deux cycles successifs, un calcul de différences, échantillon par échantillon, entre échantillons du cycle courant et échantillons d'un cycle précédent, un calcul d'un nombre P d'octets pour encoder lesdites différences et la formation d'un mot codé de P octets,
le ou chaque dispositif de mesure de courant est configuré pour :
- extraire un mot codé de chaque trame, et déterminer un nombre d'octets reçus et en fonction dudit nombre d'octets reçus, déterminer la méthode de décompression à appliquer.

La compression par différences met en oeuvre, pour une série comportant un premier cycle et un deuxième cycle successifs, pour la compression des échantillons dudit deuxième cycle, un calcul de différences, échantillon par échantillon, entre échantillons du deuxième cycle et échantillons du premier cycle, pour former une série de valeurs de différences à coder.

La compression par différences met en oeuvre, pour une série comportant un premier cycle, un deuxième cycle et un troisième cycle successifs, pour la compression des échantillons dudit troisième cycle,
- un premier calcul de différences, échantillon par échantillon, entre échantillons du troisième cycle et échantillons du deuxième cycle pour former une série de premières différences,
- un deuxième calcul de différences, échantillon par échantillon, entre échantillons du deuxième cycle et échantillons du premier cycle pour former une série de deuxièmes différences,
- un calcul d'une différence entre la série de premières différences et la série de deuxièmes différences pour former une série de valeurs de différences à coder.

Le dispositif de mesure de tension est en outre configuré pour déterminer un minimum et un maximum de ladite série de valeurs de différences à coder, puis un nombre B de bits pour coder chaque valeur de la série de valeurs de différence en fonction desdits minimum et maximum.

Le dispositif de mesure de tension est en outre configuré pour déterminer une valeur de gain en fonction desdits minimum et maximum de ladite série de valeurs de différences à coder, et pour coder ladite valeur de gain.

Une table de codage indiquant pour chaque intervalle d'une pluralité d'intervalles de valeurs de différences, le nombre de bits B pour coder chaque valeur de la série de valeurs de différence à utiliser pour ledit intervalle, et un nombre P d'octets de codage associé, est préalablement mémorisée par ledit dispositif de mesure de tension et par le ou chaque dispositif de mesure de courant.

Le ou chaque dispositif de mesure de courant, pour déterminer une méthode de décompression à appliquer, détermine si le nombre d'octets reçus appartient à ladite table de codage, et en cas de réponse positive, détermine le nombre B de bits utilisé pour coder chaque valeur de la série de valeurs de différence.

Dans le cycle initial, chaque échantillon de tension ayant une valeur d'amplitude et une valeur de phase, le mot codé est formé par codage desdites valeurs d'amplitude et de phase.

Selon un autre aspect, l'invention concerne un procédé de mesure de puissance électrique mis en oeuvre par un système distribué de mesure de puissance électrique tel que brièvement décrit ci-dessus. Le procédé comporte des étapes mises en oeuvre par une unité de calcul électronique du dispositif de mesure de tension, comportant, durant une période de transmission comportant une pluralité de cycles successifs dudit signal électrique, un codage des échantillons de tension pour former un mot codé et une transmission dudit mot codé dans une trame de communication dudit protocole de communication au ou à chaque dispositif de mesure de courant,
et comporte des étapes, mises en œuvre par une unité de calcul électronique d'au moins un dispositif de mesure de courant, de
- réception d'au moins deux trames de communication successives, chaque trame de communication correspondant à un cycle du signal électrique,
- pour chaque trame, détermination d'une méthode de décompression à appliquer et application de ladite méthode de décompression pour obtenir N échantillons de tension décodés pour le cycle correspondant,
- calcul d'une série de N valeurs de puissance pour le cycle correspondant en utilisant les échantillons de courant mesurés et les échantillons de tension décodés.

Selon un autre aspect, l'invention concerne un programme logiciel comportant un premier logiciel comportant des instructions de code et un deuxième logiciel comportant des instructions de code, qui, lorsque le premier logiciel est exécuté sur un dispositif de mesure de tension et le deuxième logiciel est exécuté sur au moins un dispositif de mesure de courant, mettent en œuvre un procédé de mesure de puissance électrique dans une installation électrique tel que brièvement décrit ci-dessus.

D'autres caractéristiques et avantages de l'invention ressortiront de la description qui en est donnée ci-dessous, à titre indicatif et nullement limitatif, en référence aux figures annexées, parmi lesquelles :
[Fig 1] la figure 1 représente schématiquement un système distribué de mesure de puissance électrique selon l'invention ;
[Fig 2] la figure 2 est un synoptique des principales étapes mises en œuvre par un dispositif de mesure de tension selon un premier mode de réalisation ;
[Fig 3] la figure 3 est un synoptique des principales étapes mises en œuvre par un dispositif de mesure de courant selon le premier mode de réalisation ;
[Fig 4] la figure 4 est un synoptique d'étapes d'un deuxième mode de réalisation, différentes des étapes du premier mode de réalisation, mises en œuvre par un dispositif de mesure de tension ;
[Fig 5] la figure 5 est un synoptique d'étapes d'un deuxième mode de réalisation, différentes des étapes du premier mode de réalisation, mises en œuvre par un dispositif de mesure de courant.

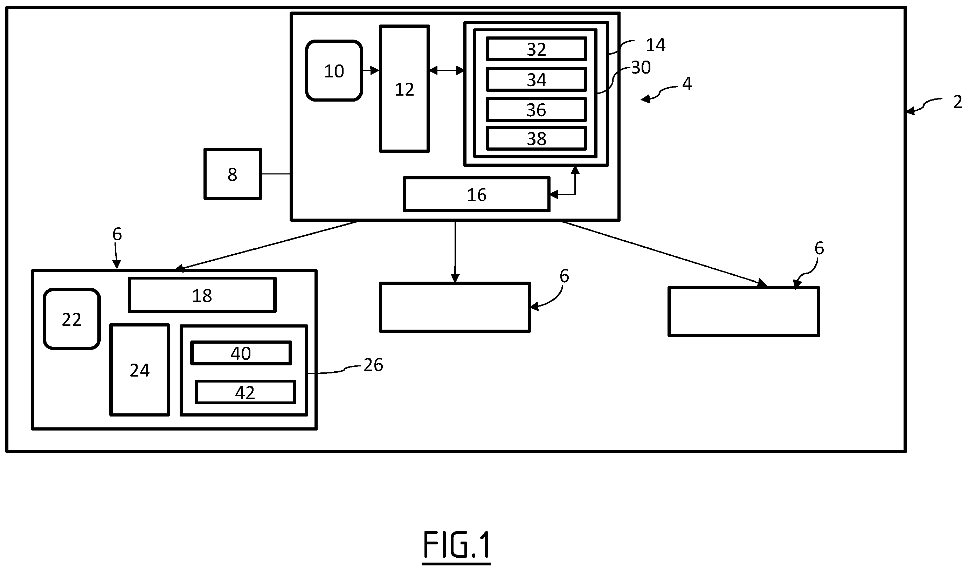

La **figure 1** représente schématiquement un mode de réalisation d'un système distribué de mesure de puissance électrique 2, adapté à fournir des mesures de puissance électrique dans une installation électrique (non représentée) alimentée par un signal électrique alternatif cyclique.

Le système 2 comporte un dispositif de mesure de tension 4 et une pluralité de dispositifs de mesure de courant 6, qui sont distants du dispositif de mesure de tension 4, les dispositifs 4 et 6 étant des dispositifs numériques de mesure électronique de tension et de courant.

Par exemple, le dispositif de mesure de tension 4 est placé à un endroit de l'installation électrique, et les dispositifs de mesure de courant 6 sont distribués à plusieurs autres endroits de l'installation électrique.

L'exemple de la figure 1 comprend trois dispositifs de mesure de courant 6, mais en pratique le nombre de dispositifs de mesure de courant 6 est quelconque. Seul un de ces dispositifs de mesure de courant 6 est représenté de manière détaillée dans la figure 1, étant entendu que tous les dispositifs de mesure de courant 6 ont une structure et des fonctionnalités analogues.

Le dispositif de mesure de tension 4 est alimenté en énergie électrique par une source d'énergie électrique 8, représentée schématiquement.

La source d'énergie électrique 8 a été schématiquement représentée à l'extérieur du dispositif de mesure de tension 4, mais selon des variantes de réalisation, la source d'énergie électrique 8 est placée à l'intérieur de ce dispositif de mesure de tension 4.

Dans un mode de réalisation, la source d'énergie électrique 8 est une alimentation à 24V.

Selon une variante, la source d'énergie électrique 8 est le réseau de distribution électrique dont la tension est mesurée.

Dans une autre variante, la source d'énergie électrique 8 est une pile, par exemple placée à l'intérieur du dispositif de mesure de tension 4.

Le dispositif de mesure de tension 4 comporte également un capteur de tension 10, adapté pour prélever des mesures de tensions sur commande ou à des intervalles temporels fixés.

Par exemple, le capteur de tension 10 est adapté pour mesurer des valeurs de tension d'un signal électrique alternatif cyclique.

De manière connue, un tel signal électrique est sensiblement périodique, par exemple sensiblement sinusoïdal, et comporte des cycles, chaque cycle correspondant à une période sinusoïdale. Selon des variantes, le signal électrique est de type triangle ou carré.

Par exemple, le capteur de tension 10 est configuré pour acquérir un nombre N prédéterminé d'échantillons de tension par cycle dudit signal électrique.

Le nombre N est choisi, par exemple N=40 par cycle du signal électrique, pour respecter les exigences des normes de performance des appareils de mesure électroniques numériques, en particulier la norme IEC 61557-12.

Le dispositif de mesure de tension 4 comporte en outre une unité de mémoire électronique 12, une unité de calcul électronique 14, par exemple un processeur ou un microcontrôleur, et un module de communication 16.

Dans un mode de réalisation les échantillons de tension mesurés sont horodatés, et mémorisés dans l'unité de mémoire électronique 12, avec une information d'horodatage (en anglais « timestamp ») associée.

Dans un mode de réalisation, le module de communication 16 est un module de communication radio, adapté pour communiquer, en émission et en réception, selon un protocole de communication radio donné.

Le protocole de communication radio est par exemple le protocole Bluetooth, ou Bluetooth Low Energy (ou BLE), ou ZigBee.

Dans un autre mode de réalisation, le module de communication 16 permet une communication selon un protocole filaire, par exemple Ethernet, Modbus, CAN.

Selon une variante, le dispositif 4 comporte plusieurs modules de communication 16, configurés pour communiquer selon des protocoles de communication radio et filaires.

Chaque dispositif de mesure de courant 6 comporte également un module de communication 18, ainsi qu'une unité de mémoire électronique 24 et unité de calcul électronique 26, par exemple un processeur ou un microcontrôleur.

Le module de communication 18 est adapté à communiquer selon le même protocole de communication, radio et/ou filaire, que le module de communication 16.

Ainsi, le dispositif de mesure de tension 4 est configuré pour communiquer avec chaque dispositif de mesure de tension 6 selon le protocole de communication choisi.

Chaque dispositif de mesure de courant 6 comporte également un capteur de courant 22, adapté pour prélever des mesures de courant à des intervalles temporels fixés, ou en d'autres termes à pas d'échantillonnage temporel fixé.

Chaque dispositif de mesure de courant 6 est un dispositif auto-alimenté en énergie électrique, via le capteur de courant 22.

Par exemple, le capteur de courant 22 est adapté pour mesurer des valeurs de courant d'un signal électrique alternatif cyclique.

De préférence, le capteur de courant 22 est configuré pour acquérir N échantillons de courant par cycle dudit signal électrique, par exemple N=40.

En d'autres termes, le même nombre N d'échantillons de tension et de courant est obtenu respectivement par le dispositif de mesure de tension et par chaque dispositif de mesure de courant.

Le système 2 est configuré pour effectuer la transmission d'échantillons de tension mesurés, qui sont de préférence horodatés, par le dispositif de mesure de tension 4 aux dispositifs de mesure de courant 6.

Dans un mode de réalisation, les échantillons de tension mesurés sont transmis à chaque cycle du signal électrique.

Chacun de ces dispositifs de mesure de courant 6 effectue en outre l'acquisition d'échantillons de courant par cycle, et ainsi un calcul distribué de mesure de tension par cycle du signal électrique est réalisé, à partir des échantillons de tension reçus et des échantillons de courant acquis.

Afin d'économiser l'énergie électrique consommée par les dispositifs de mesure de tension et de courant, le système 2 est configuré pour mettre en oeuvre une compression des échantillons de tension avant leur transmission par le dispositif de mesure de tension 4, et une décompression par chaque dispositif de mesure de courant 6.

Ainsi, avantageusement, la quantité de données émises par le dispositif de mesure de tension 4 et reçues par le ou chaque dispositif de mesure de courant 6 est réduite, ce qui permet de diminuer la durée de communication pour les modules de communication respectifs 16 et 18, dont la consommation électrique est supérieure à la consommation électrique des unités de calcul 14 et 26, qui sont par exemple des processeurs de calcul de type CPU (Central Processing Unit) ou MPU (Microprocessing Unit).

L'unité de calcul électronique 14 est configurée pour exécuter un module 30 de codage permettant de coder, pour chaque cycle du signal électrique, les échantillons de tension en un mot codé. Les échantillons de tension par cycle sont mémorisés dans l'unité de mémoire électronique 12, pour au moins deux cycles successifs.

Dans un mode de réalisation, des échantillons de tension reconstitués par décodage, pour au moins un cycle précédant un cycle courant, sont mémorisés dans l'unité de mémoire électronique 12.

Le module de codage 30 met en oeuvre, à partir du deuxième cycle d'une période de transmission de durée choisie, pour un premier cycle et un deuxième cycle successifs, un module 32 de calcul de différences, échantillon par échantillon, entre échantillons du deuxième cycle et échantillons du premier cycle, pour former une série de valeurs de différences à coder.

Selon une variante, le module 32 met en oeuvre un calcul de différences de différences (ou double différence) pour former une série de valeurs de différences à coder, sur une série de trois cycles comportant respectivement un premier cycle, et un deuxième cycle et un troisième cycle, comme décrit plus en détail ci-après.

Le module 30 met en oeuvre également un module 34 de détermination d'un minimum et d'un maximum de la série de valeurs de différences à coder, puis d'un nombre B de bits pour coder chaque valeur de la série de valeurs de différence en fonction desdits minimum et maximum. Le module 34 réalise en outre un calcul d'un nombre P d'octets pour le codage des échantillons du cycle courant.

Dans un mode de réalisation, le nombre P étant obtenu par multiplication du nombre B de bits par le nombre N d'échantillons de tension par cycle.

Selon une variante, le nombre P est en outre dépendant d'une valeur de gain à coder.

Enfin, le module 30 met en oeuvre un module 36 de codage de la série de valeurs de différences en un mot codé de P bits. Le mot codé est transmis au module de communication 16 pour une transmission dans une trame de communication selon le protocole de communication choisi.

Dans un mode de réalisation, le module 30 met également en oeuvre un module 38 de décodage qui calcule les valeurs d'échantillons de tensions reconstitués par décodage, analogues aux échantillons de tension décodés par les dispositifs de mesure de courant.

Dans un mode de réalisation, les modules 32, 34, 36 et 38 sont réalisés chacun sous forme d'un premier logiciel.

En variante non représentée, les modules 32, 34, 36 et 38 sont réalisés chacun sous forme d'un composant logique programmable, tel qu'un FPGA (de l'anglais *Field Programmable Gate Array*), ou encore sous forme d'un circuit intégré dédié, tel qu'un ASIC (de l'anglais *Application Specific Integrated Circuit*).

Le premier logiciel est en outre apte à être enregistré, sous forme de programme exécutable comportant des instructions logicielles, sur un support non volatile, non représenté, lisible par un dispositif électronique programmable.

Chaque dispositif de mesure de courant 6 reçoit les mots codés représentatifs des échantillons de tension par cycle.

L'unité de calcul électronique 26 est configurée pour exécuter un module 40 de décompression qui détermine, pour chaque mot codé reçu, une méthode de décompression à appliquer en fonction du nombre d'octets sur lequel est codé le mot codé reçu, et applique la méthode de décompression choisie pour obtenir N échantillons de tension décodés pour le cycle courant.

L'unité de calcul électronique 26 est également configurée pour exécuter un module 42 de calcul de puissance qui calcule une série de valeurs de puissance à partir des échantillons de courant acquis par le capteur 22 et des échantillons de tension décodés.

Dans un mode de réalisation, les modules 40, 42 sont réalisés chacun sous forme d'un deuxième logiciel.

En variante non représentée, les modules 40, 42 sont réalisés chacun sous forme d'un composant logique programmable, tel qu'un FPGA (de l'anglais *Field Programmable Gate Array*), ou encore sous forme d'un circuit intégré dédié, tel qu'un ASIC (de l'anglais *Application Specific Integrated Circuit).*

Le deuxième logiciel est en outre apte à être enregistré, sous forme de programme exécutable comportant des instructions logicielles, sur un support non volatile, non représenté, lisible par dispositif électronique programmable.

Le premier logiciel et le deuxième logiciel sont adaptés pour coopérer et forment un logiciel (ou programme d'ordinateur) mettant en oeuvre un procédé distribué de mesure de puissance électrique.

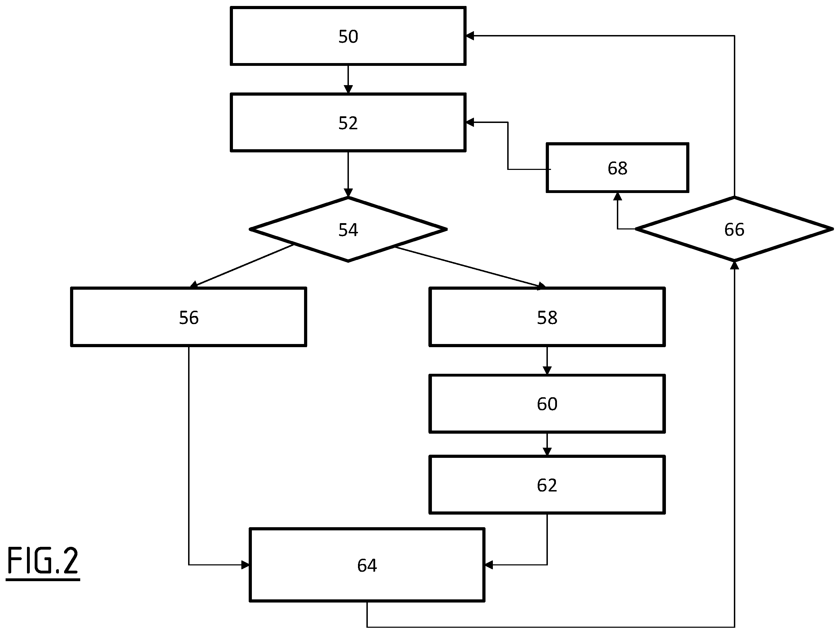

La **figure 2** est un synoptique des principales étapes d'un procédé distribué de mesure de puissance électrique, mises en oeuvre par un dispositif de mesure de tension dans un premier mode de réalisation.

Le procédé comprend une initialisation 50, lors de laquelle un indice i de cycle courant d'une période de transmission est initialisé à 0.

L'indice 0 correspond à un premier cycle, également appelé cycle initial, de la période de transmission.

La période de transmission a une durée choisie, par exemple égale à 1 seconde. Ainsi, pour un signal électrique de fréquence égale à 50Hz, une période de transmission comporte 50 cycles.

Le procédé comprend une étape 52 d'acquisition de N échantillons de tension pour le cycle courant, et une mémorisation de ces échantillons de tension.

Le nombre N d'échantillons par cycle est prédéterminé, par exemple N=40.

Le pas d'échantillonnage temporel du capteur de tension est ajusté pour obtenir N échantillons par cycle.

Selon une variante, le pas d'échantillonnage temporel du capteur de tension est différent de N, et un calcul d'interpolation est utilisé à l'étape 52 pour obtenir N échantillons par cycle.

Le procédé comporte ensuite une étape de test 54 pour déterminer si le cycle courant est le premier cycle (ou cycle initial) de la période de transmission.

Pour réaliser ce test, la valeur de l'indice i de cycle est comparée à la valeur d'initialisation, donc à zéro dans ce mode de réalisation.

En cas de réponse positive, i.e. si l'indice i de cycle est égal à zéro, une méthode de codage spécifique des échantillons de tension du premier cycle est appliquée à l'étape de codage des échantillons 56.

Par exemple, le signal électrique étant un signal sinusoïdal, les valeurs d'amplitude et de phase sont codées pour chaque échantillon de tension. Dans un mode de réalisation, la valeur d'amplitude est codée sur 2 octets et la phase est codée sur 2 octets.

En cas de réponse négative à l'étape de test 54, le cycle courant est le deuxième cycle ou un cycle ultérieur.

Le procédé comprend une étape 58 de compression par différences, qui met en oeuvre un calcul des différences, échantillon par échantillon, entre échantillons de tension du cycle courant d'indice i et les échantillons de tension du cycle d'indice i-1, préalablement mémorisés, pour former une série de valeurs de différences à coder.

Si on note $\left\{{S}_{1}^{i},..;,{S}_{j}^{i},…,{S}_{N}^{i}\right\}$ une série de N échantillons du cycle d'indice i, la série de valeurs des différences est notée : $D \left(i,i-1\right) = \left\{{S}_{1}^{i}-{S}_{1}^{i - 1},…,{S}_{N}^{i}-{S}_{N}^{i - 1}\right\}$.

Dans un mode de réalisation la différence est effectuée entre valeurs d'amplitude des échantillons de tension du cycle courant d'indice i et des valeurs d'amplitude de tension du cycle précédent qui sont reconstituées par décodage, et mémorisées à chaque cycle.

La reconstitution (ou décodage) est effectuée selon le calcul décrit ci-après en référence à l'étape de décodage 82.

Ensuite, lors d'une étape 60 de détermination d'un nombre B de bits à utiliser pour coder chaque valeur de différence, le procédé détermine un minimum et un maximum de la série de valeurs de différences à coder. Le nombre B de bits pour coder chaque valeur de la série de valeurs de différence en est déduit.

Par exemple, une table de codage associant un nombre B de bits à un intervalle de valeurs de différences est utilisée. En d'autres termes, l'intervalle de codage choisi est l'intervalle auquel appartiennent le minimum et le maximum de la série de valeurs de différences à coder.

Dans un mode de réalisation, la table 1 est utilisée.

**[TAB 1] Table 1 : intervalles de codage et nombre B de bits par valeur de différence à coder**

| Minimum | Maximum | B | P |
|---|---|---|---|
| -1 | 0 | 1 | 5 |
| -2 | 1 | 2 | 10 |
| -4 | 3 | 3 | 15 |
| -8 | 7 | 4 | 20 |
| -16 | 15 | 5 | 25 |
| -32 | 31 | 6 | 30 |
| -64 | 63 | 7 | 35 |
| -128 | 127 | 8 | 40 |

Dans la table 1, le nombre P d'octets utilisés pour former un mot codé par cycle est également indiqué.

On constate que P=BxN/8, avec N=40 dans cet exemple.

Il est entendu que la table 1 est donnée à titre d'exemple, et que d'autres tables pourraient être utilisées, par exemple avec des valeurs de Minimum et de Maximum décalées d'un décalage de +1. Un tel décalage permet de préserver une moyenne centrée sur 0 pour chaque intervalle ;

Dans un mode de réalisation, si le minimum Vₘᵢₙ est inférieur à -128 ou si le maximum Vₘₐₓ est supérieur à 127, le codage est modifié par ajout d'une valeur de gain G, qui est codé en plus, le gain G étant par exemple le diviseur qui permet de ramener chacune des valeurs respectives Vₘᵢₙ et Vₘₐₓ dans l'intervalle considéré : $\frac{{V}_{max}}{G} ⊂ \left[-128,127\right]$ et $\frac{{V}_{min}}{G} ⊂ \left[-128,127\right]$ . Chacune des valeurs de différence à coder est alors divisée par G, ce qui induit une légère perte de précision.

Par exemple la valeur de gain est codée sur un octet supplémentaire, ajouté aux P=40 octets du dernier intervalle [-128, 127]. Dans ce cas, la table de codage est enrichie d'un nombre P d'octets égal à 41 pour le codage avec gain.

Ensuite, lors d'une étape de codage 62 chaque valeur de différence est codée sur B bits, par exemple sur la base d'une table de codage prédéterminée, par exemple la table 1 donnée ci-dessus.

Le procédé comporte enfin une étape 64 de mise en forme du mot codé dans une trame de communication selon le protocole de communication choisi, et transmission du mot codé.

Par exemple, le protocole de communication choisi est le protocole Bluetooth ou le protocole ZigBee.

L'étape 64 est suivie d'une étape 66 consistant à vérifier si tous les cycles de la période de transmission ont été traités. Par exemple, l'indice de cycle i est comparé à une valeur maximale prédéterminée d'indice de cycle par période de transmission, et il est vérifié à l'étape 66 si l'indice de cycle courant est égal à cette valeur maximale prédéterminée.

L'étape 66 est suivie de l'étape 68 si la réponse est négative, lors de laquelle l'indice de cycle courant est incrémenté de 1 pour le traitement du cycle suivant. L'étape 68 est suivie de l'étape 52 préalablement décrite.

Si la réponse est positive, l'étape 66 est suivie de l'étape 50 préalablement décrite.

En d'autres termes, lorsque le dernier cycle d'un période de transmission est traité, le procédé retourne à l'étape 50 pour une période de transmission suivante.

Avantageusement, cela permet de coder les échantillons de tension du cycle initial de la nouvelle période de transmission, et par conséquent d'obtenir un codage par différences plus efficace.

Il est à noter qu'en plus des séries de valeurs de différences par cycle, des informations d'horodatage (en anglais « timpestamp ») sont transmises pour permettre la réalisation d'une synchronisation par les dispositifs de mesure de courant, en particulier pour permettre une synchronisation entre horloges du dispositif de mesure de tension et de chaque dispositif de mesure de courant. Par exemple, l'information d'horodatage est également compressée, par exemple par une compression par double différence. Tout procédé de synchronisation connu peut être mis en œuvre pour réaliser une telle synchronisation.

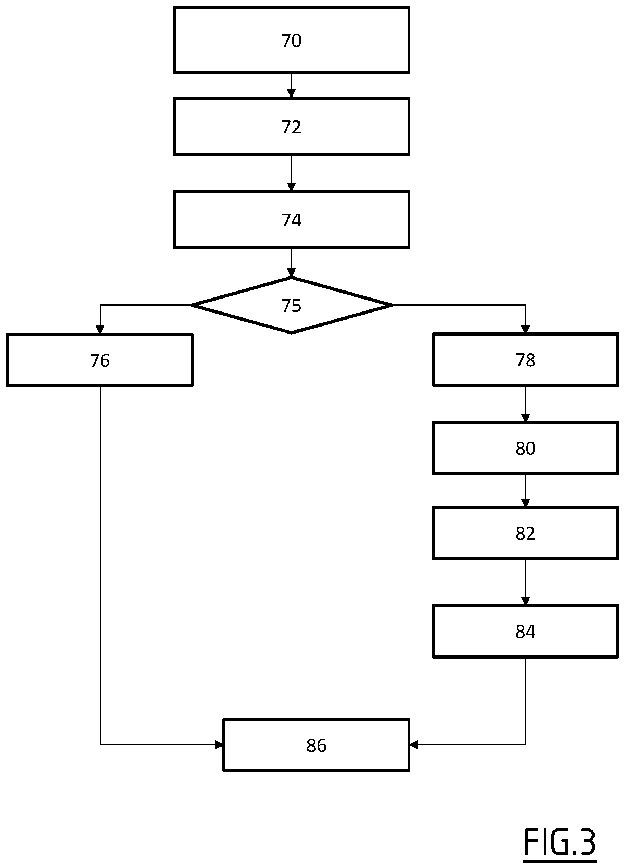

La **figure 3** est un synoptique des principales étapes d'un procédé distribué de mesure de puissance électrique, mises en œuvre par un dispositif de mesure de courant, dans le premier mode de réalisation.

Dans ce premier mode de réalisation, chaque dispositif de mesure de courant reçoit des trames comportant des mots codés, chaque mot codé comportant des données représentatives des échantillons de tension par cycle, obtenus par les étapes de procédé décrites en référence à la figure 2.

Ce procédé comporte une étape 70 de réception de trames de communication, chaque trame comportant un mot codé correspondant à un cycle de signal électrique, et une étape 72 de mémorisation des mots codés extraits.

Ensuite, lors d'une étape 74 de détermination du nombre d'octets, le nombre P d'octets sur lequel est représenté le mot codé extrait de la trame courante est déterminé.

En fonction du nombre P d'octets, le procédé détermine une méthode de décompression pour obtenir, à partir du mot codé, N échantillons de tension décodés pour le cycle correspondant.

Lors d'une étape de test 75 il est vérifié si le nombre P appartient à une table de codage utilisée lors du codage, par exemple à la table 1, comme décrit en référence à la figure 2.

Si le nombre P n'appartient pas à une table de codage utilisée lors du codage (réponse négative à l'étape 75), il est déduit que le cycle courant est un premier cycle (ou cycle initial) d'une période de transmission.

Les valeurs d'amplitude et de phase des N échantillons de tension de ce premier cycle d'une période de transmission sont décodées et mémorisées lors d'une étape 76.

Ce décodage est un décodage spécifique correspondant à la méthode de codage spécifique des échantillons du premier cycle mise en oeuvre à l'étape 56.

Si le nombre P est un nombre appartenant à une table de codage utilisée, la table de codage étant partagée avec le dispositif de mesure de tension qui transmet les échantillons de tension codés, alors il est déduit, lors d'une étape 78, quel est le nombre B de bits utilisé pour coder chaque valeur de différence.

En variante, sans utiliser de table de codage mémorisée, à l'étape 75 il est vérifié si le nombre P d'octets multiplié par 8 et divisé par le nombre N d'échantillons par cycle est un nombre entier compris entre 1 et 8, et ce nombre étant le nombre B de bits par valeur de différence.

L'étape 78 est suivie d'une étape 80 de décodage pour obtenir N valeurs de différences décodées, qui sont mémorisées.

Par exemple, le mot codé reçu est divisé en N mots de B bits, chaque mot de B bits représentant une valeur de différence, selon la table de codage utilisée pour le codage.

Ensuite, lors d'une étape de décodage 82, des échantillons de tension décodés sont obtenus, à partir des valeurs de différences décodées et de valeurs d'échantillons de tension préalablement mémorisées pour un cycle précédent.

Par exemple, si le cycle courant a un indice i associé, les valeurs d'échantillons de tension décodées et préalablement mémorisées pour le cycle d'indice i-1 sont utilisées.

En d'autres termes, si on note *D*(*i*, *i* - 1) = {Δ₁, ... , *Δ_{N}*} la série de valeurs de différences décodées, et $\left\{{V}_{1}^{i - 1},..,{V}_{N}^{i - 1}\right\}$ une série de N échantillons de tension décodés pour le cycle (i-1), les valeurs d'échantillons sont obtenus par la formule : ${V}_{j}^{i} = {V}_{j}^{i - 1} + {Δ}_{j}$

Les N valeurs d'échantillons de tension décodées pour le cycle d'indice i courant sont mémorisées également, lors d'une étape de mémorisation 84.

Les étapes 76 et 84 sont suivies d'une étape 86 de calcul de N valeurs de puissance à partir des N échantillons de tension décodés et des N échantillons de courant correspondants acquis par le capteur de courant du dispositif de mesure de courant.

En plus des étapes du procédé décrites ci-dessus, ayant pour objectif l'obtention des échantillons de tension décodés pour réaliser le calcul des valeurs de puissance, le procédé comporte une synchronisation en fonction d'informations d'horodatage reçues, par toute méthode adéquate.

Les étapes 70 à 86 sont répétées pour chaque nouvelle trame reçue.

Ainsi, après réception d'une trame correspondant à un premier cycle d'une période de transmission, des séries de N échantillons de tension décodés sont obtenues pour chaque cycle successif.

Le premier mode de réalisation décrit en référence aux figures 2 et 3, met en oeuvre une compression par différence entre échantillons de cycles successifs.

Selon un deuxième mode de réalisation, en variante, le procédé distribué de mesure de puissance électrique met en oeuvre une compression par différences de différences (ou double différences).

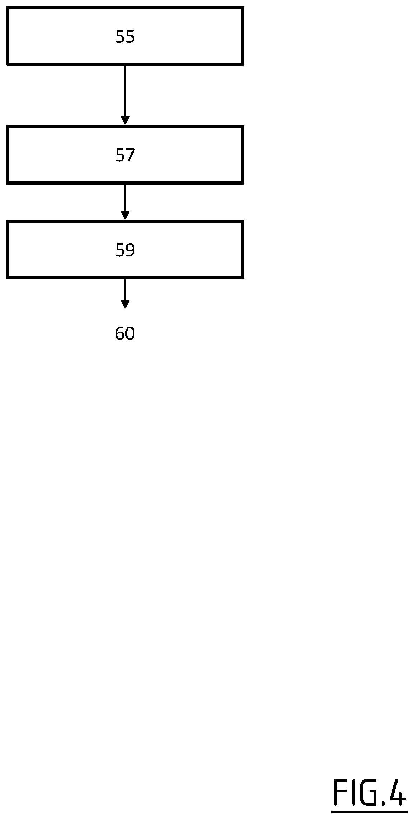

Des étapes de ce deuxième mode de réalisation, différentes des étapes du premier mode de réalisation, mises en oeuvre par le dispositif de mesure de tension, sont illustrées en référence à la figure 4.

Dans ce mode de réalisation, le test 54 permet en outre de déterminer si le cycle courant est un troisième cycle ou un cycle suivant de la période de transmission.

Le premier cycle (cycle initial) est codé de manière analogue au premier mode de réalisation, et le deuxième cycle est codé par différence (simple) selon le procédé décrit en référence à la figure 2.

A partir du troisième cycle d'une période de transmission, l'étape 54 est suivie d'un traitement pour une série comportant un premier cycle d'indice i-2, un deuxième cycle d'indice i-1 et un troisième cycle (cycle courant) d'indice i.

Ce traitement comporte un premier calcul de différences (étape 55), échantillon par échantillon, entre échantillons du troisième cycle et échantillons du deuxième cycle pour former une série de premières différences : ${D}_{1} \left(i,i-1\right) = \left\{{S}_{1}^{i}-{S}_{1}^{i - 1},…,{S}_{N}^{i}-{S}_{N}^{i - 1}\right\}$

En d'autres termes, les différences entre échantillons du cycle d'indice i et les échantillons du cycle de l'indice (i-1) sont calculées.

Dans un mode de réalisation, les échantillons du deuxième cycle sont reconstitués par décodage.

De plus, un deuxième calcul de différences (étape 57) est effectué, échantillon par échantillon, entre échantillons du deuxième cycle, d'indice (i-1) et échantillons du premier cycle, d'indice (i-2), pour former une série de deuxièmes différences : ${D}_{2} \left(i-1,i-2\right) = \left\{{S}_{1}^{i - 1}-{S}_{1}^{i - 2},…,{S}_{N}^{i - 1}-{S}_{N}^{i - 2}\right\}$

Dans un mode de réalisation, les échantillons du premier cycle sont reconstitués par décodage.

Selon une variante, les différences, calculées lors du premier calcul de différences, échantillon par échantillon, entre les échantillons d'un cycle courant et les échantillons d'un cycle précédent sont mémorisées à chaque itération.

L'étape 57 de deuxième calcul des différences est remplacées par une étape de lecture en mémoire des différences mémorisées à l'étape précédente.

Ensuite, l'étape 59 met en oeuvre un calcul d'une différence entre la série de premières différences et la série de deuxième différences pour former une série de valeurs de différences à coder : $DD \left(i-2,i-1,i\right) = {D}_{2} \left(i-1,i-2\right) - {D}_{1} \left(i,i-1\right)$

L'étape 59 est suivie de l'étape 60 de détermination d'un nombre B de bits à utiliser pour coder chaque valeur de différence, préalablement décrite en référence à la figure 2.

Avantageusement, dans ce deuxième mode de réalisation, les valeurs de différences à coder sont des différences de différences, ce qui permet d'augmenter le taux de compression.

Pour ce deuxième mode de réalisation, chaque dispositif de mesure de courant met en oeuvre une méthode de décompression correspondante, pour une série de cycles comportant un premier, un deuxième et un troisième cycle successifs, d'indices respectifs i-2, i-1 et i.

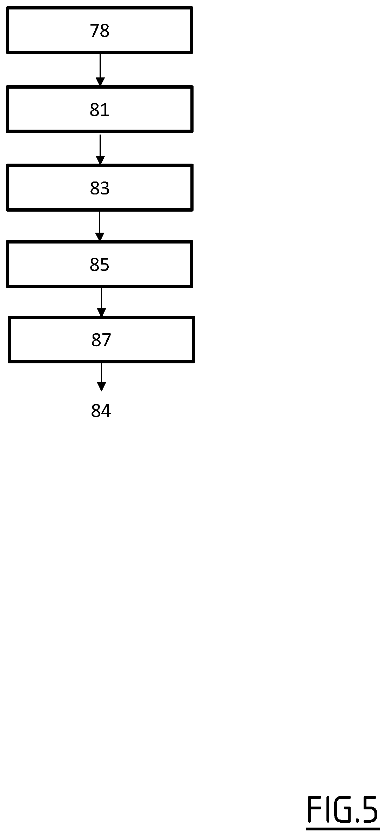

Les étapes spécifiques de ce deuxième mode de réalisation mises en oeuvre par un dispositif de mesure de courant sont illustrées dans le synoptique de la figure 5.

Pour un cycle i courant, le procédé met en oeuvre, après l'étape 78 préalablement décrite, une étape 81 de décodage pour obtenir N valeurs de différences de différences décodées, correspondant respectivement aux différences DD(i-2,i-1,i).

Le procédé comprend une étape suivante 83 d'obtention des valeurs de différences entre cycle d'indice (i-1) et cycle d'indice (i-2), préalablement décodées et mémorisées, et une étape 85 de calcul des valeurs de différences décodées entre cycle d'indice i et cycle d'indice (i-1) : ${D}_{1} \left(i,i-1\right) = {D}_{2} \left(i-1,i-2\right) - DD \left(i-2,i-1,i\right)$

Les valeurs de différences décodées calculées à l'étape 85 sont également mémorisées à cette étape, pour une utilisation à une étape suivante.

Ensuite, le procédé comprend un calcul 87 des échantillons de tension décodés pour le cycle courant d'indice i à partir des valeurs de différences décodées DD(i, i-1) et des valeurs d'échantillons de tension décodées et mémorisées pour le cycle d'indice (i-1).

Les échantillons de tension décodés pour le cycle courant d'indice i sont mémorisées à l'étape de mémorisation 84, préalablement décrite.

Avantageusement, le procédé de calcul de puissance distribué met en œuvre une compression/décompression qui permet d'obtenir un bon taux de compression, y compris en cas de fluctuations du signal électrique, et par conséquent de permettre de diminuer la consommation électrique des divers dispositifs mis en œuvre.

Avantageusement, la compression par différences ou par différences de différences utilisée est simple et permet de diminuer la charge calculatoire.

## Revendications

1. Système distribué de mesure de puissance électrique dans une installation électrique alimentée par un signal électrique alternatif cyclique, le système (2) comportant un dispositif de mesure de tension (4) et au moins un dispositif de mesure de courant (6) distant du dispositif de mesure de tension (4),
le dispositif de mesure de tension (4) étant configuré pour acquérir un nombre N prédéterminé d'échantillons de tension par cycle dudit signal électrique,
chaque dispositif de mesure de courant (6) étant configuré pour acquérir N échantillons de courant par cycle dudit signal électrique,
le dispositif de mesure de tension (4) et le ou chaque dispositif de mesure de courant (6)étant adaptés pour communiquer selon un protocole de communication,
le système (2) étant **caractérisé en ce que** :
le dispositif de mesure de tension (4) est configuré pour, durant une période de transmission comportant une pluralité de cycles successifs dudit signal électrique,
- pour chaque cycle, coder (30) les échantillons de tension pour former un mot codé et transmettre ledit mot codé dans une trame de communication dudit protocole de communication au ou à chaque dispositif de mesure de courant,
le ou chaque dispositif de mesure de courant (6) est configuré pour :
- recevoir au moins deux trames de communication successives, chaque trame de communication correspondant à un cycle du signal électrique,
- pour chaque trame, déterminer (40) une méthode de décompression à appliquer et appliquer ladite méthode de décompression pour obtenir N échantillons de tension décodés pour le cycle correspondant,
- calculer (42) une série de N valeurs de puissance pour le cycle correspondant en utilisant les échantillons de courant mesurés et les échantillons de tension décodés.

2. Système selon la revendication 1, ladite pluralité de cycles successifs comportant un cycle initial et des cycles suivants, dans lequel le dispositif de mesure de tension est configuré pour appliquer, pour les échantillons de tension de chaque cycle courant distinct du cycle initial, une compression par différences mettant en oeuvre pour au moins deux cycles successifs, un calcul de différences, échantillon par échantillon, entre échantillons du cycle courant et échantillons d'un cycle précédent, un calcul d'un nombre P d'octets pour encoder lesdites différences et la formation d'un mot codé de P octets ;
le ou chaque dispositif de mesure de courant (6) est configuré pour :
- extraire un mot codé de chaque trame, et déterminer un nombre d'octets reçus et en fonction dudit nombre d'octets reçus, déterminer la méthode de décompression à appliquer.

3. Système selon la revendication 2, dans lequel la compression par différences met en oeuvre, pour une série comportant un premier cycle et un deuxième cycle successifs, pour la compression des échantillons dudit deuxième cycle, un calcul de différences, échantillon par échantillon, entre échantillons du deuxième cycle et échantillons du premier cycle, pour former une série de valeurs de différences à coder.

4. Système selon la revendication 2 ou 3, dans lequel la compression par différences met en oeuvre, pour une série comportant un premier cycle, un deuxième cycle et un troisième cycle successifs, pour la compression des échantillons dudit troisième cycle,
- un premier calcul de différences, échantillon par échantillon, entre échantillons du troisième cycle et échantillons du deuxième cycle pour former une série de premières différences,
- un deuxième calcul de différences, échantillon par échantillon, entre échantillons du deuxième cycle et échantillons du premier cycle pour former une série de deuxièmes différences,
- un calcul d'une différence entre la série de premières différences et la série de deuxièmes différences pour former une série de valeurs de différences à coder.

5. Système selon l'une des revendications 2 à 4, dans lequel le dispositif de mesure de tension est en outre configuré pour déterminer un minimum et un maximum de ladite série de valeurs de différences à coder, puis un nombre B de bits pour coder chaque valeur de la série de valeurs de différence en fonction desdits minimum et maximum.

6. Système selon la revendication 5, dans lequel le dispositif de mesure de tension est en outre configuré pour déterminer une valeur de gain en fonction desdits minimum et maximum de ladite série de valeurs de différences à coder, et pour coder ladite valeur de gain.

7. Système selon la revendication 5 ou 6, dans lequel une table de codage indiquant pour chaque intervalle d'une pluralité d'intervalles de valeurs de différences, le nombre de bits B pour coder chaque valeur de la série de valeurs de différence à utiliser pour ledit intervalle, et un nombre P d'octets de codage associé, est préalablement mémorisée par ledit dispositif de mesure de tension et par le ou chaque dispositif de mesure de courant.

8. Système selon la revendication 7, dans lequel le ou chaque dispositif de mesure de courant, pour déterminer une méthode de décompression à appliquer, détermine si le nombre d'octets reçus appartient à ladite table de codage, et en cas de réponse positive, détermine le nombre B de bits utilisé pour coder chaque valeur de la série de valeurs de différence.

9. Système selon l'une des revendications 2 à 8, dans lequel pour le cycle initial, chaque échantillon de tension ayant une valeur d'amplitude et une valeur de phase, le mot codé est formé par codage desdites valeurs d'amplitude et de phase.

10. Procédé distribué de mesure de puissance électrique dans une installation électrique, mis en œuvre par un système distribué de mesure de puissance électrique conforme aux revendications 1 à 8, comportant des étapes mises en œuvre par une unité de calcul électronique du dispositif de mesure de tension, comportant, durant une période de transmission comportant une pluralité de cycles successifs dudit signal électrique, un codage des échantillons (56, 58-62, 55-59) de tension pour former un mot codé et une transmission (64) dudit mot codé dans une trame de communication dudit protocole de communication au ou à chaque dispositif de mesure de courant,
et comportant des étapes, mises en œuvre par une unité de calcul électronique d'au moins un dispositif de mesure de courant, de :
- réception (70) d'au moins deux trames de communication successives, chaque trame de communication correspondant à un cycle du signal électrique,
- pour chaque trame, détermination (72-75) d'une méthode de décompression à appliquer et application de ladite méthode de décompression (76, 78-82, 81-87) pour obtenir N échantillons de tension décodés pour le cycle correspondant,
- calcul (86) d'une série de N valeurs de puissance pour le cycle correspondant en utilisant les échantillons de courant mesurés et les échantillons de tension décodés.

11. Programme logiciel comportant un premier logiciel comportant des instructions de code et un deuxième logiciel comportant des instructions de code, qui, lorsque le premier logiciel est exécuté sur un dispositif de mesure de tension et le deuxième logiciel est exécuté sur au moins un dispositif de mesure de courant, mettent en œuvre un procédé de mesure de puissance électrique dans une installation électrique selon la revendication 10.

## Patentansprüche

1. Verteiltes System zur Messung elektrischer Leistung in einer elektrischen Anlage, die von einem zyklischen elektrischen Wechselstromsignal gespeist wird, das System (2) umfassend eine Spannungsmessvorrichtung (4) und mindestens eine von der Spannungsmessvorrichtung (4) entfernte Strommessvorrichtung (6),
wobei die Spannungsmessvorrichtung (4) konfiguriert ist, um eine vorbestimmte Anzahl N von Spannungsabtastungen pro Zyklus des elektrischen Signals zu erfassen,
jede Strommessvorrichtung (6) konfiguriert ist, um N Stromabtastungen pro Zyklus des elektrischen Signals zu erfassen,
wobei die Spannungsmessvorrichtung (4) und die oder jede Strommessvorrichtung (6) angepasst sind, um gemäß einem Kommunikationsprotokoll zu kommunizieren,
wobei das System (2) **dadurch gekennzeichnet ist, dass**:
die Spannungsmessvorrichtung (4) während einer Übertragungsperiode, die eine Vielzahl aufeinanderfolgender Zyklen des elektrischen Signals umfasst, zu Folgendem konfiguriert ist
- für jeden Zyklus, Kodieren (30) der Spannungsabtastungen, um ein kodiertes Wort zu bilden, und Übertragen des kodierten Worts in einem Kommunikationsdatenblock des Kommunikationsprotokolls an die oder jede Strommessvorrichtung, wobei die oder jede Strommessvorrichtung (6) zu Folgendem konfiguriert ist:
- Empfangen von mindestens zwei aufeinanderfolgenden Kommunikationsdatenblöcken, wobei jeder Kommunikationsdatenblock einem Zyklus des elektrischen Signals entspricht,
- für jeden Datenblock, Bestimmen (40) einer anzuwendenden Dekomprimierungsmethode und Anwenden dieser Methode, um für den entsprechenden Zyklus N dekodierte Spannungsabtastungen zu erlangen,
- Berechnen (42) einer Reihe von N Leistungswerten für den entsprechenden Zyklus unter Verwendung der gemessenen Stromabtastungen und der dekodierten Spannungsabtastungen.

2. System nach Anspruch 1, wobei die Vielzahl von aufeinanderfolgenden Zyklen einen Anfangszyklus und nachfolgende Zyklen umfassen, wobei die Spannungsmessvorrichtung konfiguriert ist, um für die Spannungsabtastungen jedes laufenden Zyklus, der sich vom Anfangszyklus unterscheidet, eine Kompression durch Differenzen anzuwenden, die für mindestens zwei aufeinanderfolgende Zyklen eine Berechnung der Differenzen zwischen Abtastungen des laufenden Zyklus und den Abtastungen eines vorhergehenden Zyklus, einzeln für jede Abtastung, eine Berechnung einer Anzahl P von Bytes zum Kodieren der Differenzen und die Bildung eines kodierten Worts aus P Bytes umsetzt;
wobei jede Strommessvorrichtung (6) zu Folgendem konfiguriert ist:
- Extrahieren, aus jedem Datenblock, eines kodierten Worts und Bestimmen einer Anzahl empfangener Bytes, und Bestimmen, abhängig von dieser Anzahl, der anzuwendenden Dekomprimierungsmethode.

3. System nach Anspruch 2, wobei die Kompression durch Differenzen für eine Reihe die einen ersten und einen darauf folgenden zweiten Zyklus umfasst für die Kompression der Abtastungen des zweiten Zyklus eine Berechnung der Differenzen, einzeln für jede Abtastung, zwischen den Abtastungen des zweiten Zyklus und den Abtastungen des ersten Zyklus implementiert, um eine Reihe von zu kodierenden Differenzwerten zu bilden.

4. System nach Anspruch 2 oder 3, wobei die Kompression durch Differenzen für eine Reihe die einen ersten, einen zweiten und einen aufeinanderfolgenden dritten Zyklus umfasst zur Kompression der Proben des dritten Zyklus durchgeführt wird,
- eine erste Berechnung von Differenzen, einzeln für jede Abtastung, zwischen Abtastungen des dritten und des zweiten Zyklus, um eine Reihe von ersten Differenzen zu bilden,
- eine zweite Berechnung von Differenzen, einzeln für jede Abtastung, zwischen Abtastungen des zweiten und des ersten Zyklus, um eine Serie von zweiten Differenzen zu bilden,
- eine Berechnung der Differenz zwischen der Reihe der ersten und der Reihe der zweiten Differenzen, um eine Reihe zu kodierender Differenzwerte zu bilden.

5. System nach einem der Ansprüche 2 bis 4, wobei die Spannungsmessvorrichtung ferner konfiguriert ist, um ein Minimum und ein Maximum der zu kodierenden Differenzwerte und anschließend eine Anzahl B von Bits zum Kodieren jedes Werts abhängig von diesem Minimum und Maximum zu bestimmen.

6. System nach Anspruch 5, wobei die Spannungsmessvorrichtung ferner konfiguriert ist, um einen Verstärkungswert abhängig von dem Minimum und dem Maximum der Reihe von zu kodierenden Differenzwerten zu bestimmen und den Verstärkungswert zu kodieren.

7. System nach Anspruch 5 oder 6, wobei eine Kodiertabelle, die für jedes Intervall einer Vielzahl von Intervallen von Differenzwerten die Anzahl von Bits B zum Kodieren jedes Werts der Reihe von Differenzwerten, die für das Intervall zu verwenden sind, und eine zugehörige Anzahl P von Kodierbytes angibt, zuvor von der Spannungsmessvorrichtung und von der oder jeder Strommessvorrichtung gespeichert wird.

8. System nach Anspruch 7, wobei die eine oder jede Strommessvorrichtung, um die anzuwendende Dekomprimierungsmethode zu bestimmen, bestimmt, ob die Anzahl der empfangenen Bytes zu der Kodiertabelle gehört, und im Fall einer positiven Antwort die Anzahl B an Bits bestimmt, die zum Kodieren jedes Werts der Reihe von Differenzwerten verwendet wird.

9. System nach einem der Ansprüche 2 bis 8, wobei für den Anfangszyklus, bei dem jeder Spannungsabtastwert einen Amplitudenwert und einen Phasenwert aufweist, das kodierte Wort durch Kodieren der Amplituden- und Phasenwerte gebildet wird.

10. Verteiltes System zur Messung elektrischer Leistung in einer elektrischen Anlage, durchgeführt von einem verteilten System zur Messung elektrischer Leistung nach den Ansprüchen 1 bis 8, umfassend Schritte, die von einer elektronischen Recheneinheit der Spannungsmessvorrichtung durchgeführt werden und während einer Übertragungsperiode die eine Vielzahl aufeinanderfolgender Zyklen des elektrischen Signals umfasst ein Kodieren der Spannungsabtastungen (56, 58-62, 55-59) zum Bilden eines kodierten Worts sowie ein Übertragen (64) dieses kodierten Worts in einem Kommunikationsdatenblock des Kommunikationsprotokolls an die oder an jede Strommessvorrichtung umfassen,
und umfassend Schritte, die von der elektronischen Recheneinheit mindestens einer Strommessvorrichtung durchgeführt werden, zum:
- Empfangen (70) von mindestens zwei aufeinanderfolgenden Kommunikationsdatenblöcken, wobei jeder Kommunikationsdatenblock einem Zyklus des elektrischen Signals entspricht,
- für jeden Datenblock, Bestimmen (72-75) einer anzuwendenden Dekomprimierungsmethode und Anwenden der Dekomprimierungsmethode (76, 78-82, 81-87), um N dekodierte Spannungswerte für den entsprechenden Zyklus zu erlangen,
- Berechnen (86) einer Reihe von N Leistungswerten für den entsprechenden Zyklus unter Verwendung der gemessenen Strom- und dekodierten Spannungsabtastungen.

11. Softwareprogramm, umfassend eine erste und eine zweite Software, jeweils umfassend Codeanweisungen, die, wenn die erste Software auf einer Spannungsmessvorrichtung und die zweite Software auf mindestens einer Strommessvorrichtung ausgeführt werden, ein Verfahren zur Messung elektrischer Leistung in einer elektrischen Anlage nach Anspruch 10 implementieren.

## Claims

1. A distributed system for measuring electrical power in an electrical installation powered by a cyclical alternating electrical signal, the system (2) including a device for measuring voltages (4) and at least one device for measuring currents (6) remote from the device for measuring voltages (4),
the device for measuring voltages (4) being configured to acquire a predetermined number N of samples of voltage per cycle of said electrical signal,
each device for measuring currents (6) being configured to acquire N samples of current per cycle of said electrical signal,
the device for measuring voltages (4) and the or each device for measuring currents (6) being suitable for communicating according to a communication protocol,
the system (2) being **characterized in that**:
the device for measuring voltages (4) is configured, during a transmission period including a plurality of successive cycles of said electrical signal,
- for each cycle, to code (30) the samples of voltage to form a codeword and to transmit said codeword in a communication frame of said communication protocol to the or each device for measuring currents,
the or each device for measuring currents (6) is configured:
- to receive at least two successive communication frames, each communication frame corresponding to one cycle of the electrical signal,
- for each frame, to determine (40) a decompression method to be applied and apply that decompression method to obtain N decoded samples of voltage for the corresponding cycle,
- to compute (42) a series of N power values for the corresponding cycle using the measured samples of current and the decoded samples of voltage.

2. The system according to claim 1, said plurality of successive cycles including an initial cycle and subsequent cycles, wherein the device for measuring voltages is configured to apply, for the samples of voltage of each current cycle distinct from the initial cycle, a differential compression implementing for at least two successive cycles, a computation of differences, sample by sample, between samples of the current cycle and samples of a preceding cycle, a computation of a number P of bytes to code said differences and the formation of a codeword of P bytes;
the or each device for measuring currents (6) is configured:
- to extract a codeword from each frame, and determine a number of bytes received and according to said number of bytes received, to determine the decompression method to be applied.

3. The system according to claim 2, wherein the differential compression implements, for a series having a successive first cycle and second successive cycle, for the compression of the samples of said second cycle, a computation of differences, sample by sample, between samples of the second cycle and samples of the first cycle, so as to form a series of difference values to be coded.

4. The system according to claim 2 or 3, wherein the differential compression implements, for a series including a successive first cycle, second cycle and third cycle, for the compression of the samples of said third cycle,
- a first computation of differences, sample by sample, between samples of the third cycle and samples of the second cycle to form a series of first differences,
- a second computation of differences, sample by sample, between samples of the second cycle and samples of the first cycle to form a series of second differences,
- a computation of a difference between the series of first differences and the series of second differences to form a series of difference values to be coded.

5. The system according to one of claims 2 to 4, wherein the device for measuring voltages is further configured to determine a minimum and a maximum of said series of difference values to be coded, and then a number B of bits to code each of said series of difference values according to said minimum and maximum.

6. The system according to claim 5, wherein the device for measuring voltages is further configured to determine a gain value according to said minimum and maximum of said series of difference values to be coded, and to code said gain value.

7. The system according to claim 5 or 6, wherein a coding table indicating for each interval of a plurality of intervals of difference values, the number of bits B for coding each of the series of difference values to be used for said interval, and a number P of associated coding bytes, is previously stored by said device for measuring voltages and by the or each device for measuring currents.

8. The system according to claim 7, wherein the or each device for measuring currents, for determining a decompression method to be applied, determines whether the number of bytes received belongs to said coding table, and in the event of a positive response, determines the number B of bits used to code each of the series of difference values.

9. The system according to one of claims 2 to 8, wherein for the initial cycle, each sample of voltage having an amplitude value and a phase value, the codeword being formed by coding said amplitude and phase values.

10. A distributed method of measuring electrical power in an electrical installation, implemented by a distributed system for measuring electrical power according to claims 1 to 8, including steps implemented by an electronic computing unit of the device for measuring voltages, including, during a transmission period including a plurality of successive cycles of said electrical signal, a coding of samples (56, 58-62, 55-59) of voltage to form a codeword and a transmission (64) of said codeword in a communication frame of said communication protocol to the or each device for measuring currents,
and including steps, implemented by an electronic computing unit of at least one device for measuring currents:
- of reception (70) of at least two successive communication frames, each communication frame corresponding to one cycle of the electrical signal,
- for each frame, of the determination (72-75) of a decompression method to be applied and application of said decompression method (76, 78-82, 81-87) to obtain N decoded samples of voltage for the corresponding cycle,
- of computation (86) of a series of N power values for the corresponding cycle using the measured samples of current and the decoded samples of voltage.

11. A software program including a first software program including code instructions and a second software program including code instructions, which, when the first software program is executed on a device for measuring voltages and the second software program is executed on at least one device for measuring currents, implements a method for measuring electrical power in an electrical installation according to claim 10.
